# EUROPÄISCHE PATENTSCHRIFT

(11) **EP 2 671 717 B1**
(45) Veröffentlichungstag und Bekanntmachung des Hinweises auf die Patenterteilung: **02.08.2017**
(21) Anmeldenummer: 13183271.9
(22) Anmeldetag: 19.11.2008
(51) Int. Cl.: B32B 15/08, B32B 17/10, B32B 18/00, B32B 37/24, B32B 38/10, C23C 24/10, B32B 9/00

(54) **Herstellung eines funktionellen Kompositmaterials**
Production of a functional composite material
Fabrication du matériau composite fonctionnel

(30) Priorität: 23.11.2007 DE 102007056587
(43) Veröffentlichungstag der Anmeldung: 11.12.2013
(62) Teilanmeldung aus: 08852078.8
(73) Patentinhaber: SorTech AG, 06126 Halle (Saale) (DE)
(72) Erfinder: Mittelbach, Walter, 06108 Halle/Saale (DE); Herrmann, Ralph, 06118 Halle/Saale (DE); Bauer, Jürgen, 96215 Lichtenfels (DE)
(74) Vertreter: Kruspig, Volkmar

(56) Entgegenhaltungen:
- WO-A1-02/40744
- US-A- 4 248 915
- US-A1- 2003 072 930

## Beschreibung

Die Erfindung betrifft ein Verfahren zur Herstellung eines funktionellen Kompositmaterials, bestehend aus einem Träger aus metallischem Werkstoff und/oder aus keramischem Werkstoff und/oder aus Glaswerkstoff und einem funktionellen Oberflächenmaterial, nach dem Oberbegriff des Anspruchs 1.

Funktionelle Kompositmaterialien haben ein breites technisches Anwendungsgebiet. Derartige Materialien sind insbesondere bei Sorptions- und Katalyseprozessen mit deutlicher Wärmetönung von ausschlaggebender Bedeutung. Des weiteren werden sie im Bereich des Korrosions- und Antifoulingschutzes eingesetzt, um die Oberflächen chemischer und technischer Apparate gegenüber den Einflüssen aggressiver chemischer Stoffe unempfindlich zu machen bzw. Ablagerungen zu vermeiden.

Funktionelle Kompositmaterialien bestehen aus einem Trägermaterial, z.B. metallischen Werkstoffen, Keramiken oder Glaswerkstoffen und einem auf deren Oberfläche angeordneten funktionellen Material, das als Katalysator, Adsorbens, Korrosions- bzw. Antifoulingschutz, Isolator oder elektrische Funktionsschicht dient.

Bei den herkömmlichen Herstellungsverfahren werden die funktionellen Materialien als Formkörper, insbesondere Pellets, oder als Beschichtungen auf das entsprechende Trägermaterial aufgebracht. Dabei wird in den meisten Fällen die Oberfläche des Trägermaterials nicht vollständig mit dem funktionellen Material bedeckt bzw. beschichtet. Die Folge ist eine ungenügende mechanische Anbindung der funktionellen Materialien an die Trägeroberfläche und ein ungenügender thermischer Kontakt zwischen dem Trägermaterial und der Beschichtung.

Beschichtungsmethoden, die zu einer vergleichsweise festen, direkten und flächigen Berührung zwischen Trägermaterial und funktionellem Material führen, bei denen die Trägeroberfläche vollständig bedeckt wird, sind beispielsweise eine in-situ-Kristallisation, eine Aufkristallisation bzw. eine verbrauchende Aufkristallisation. Die daraus hervorgehenden mechanischen Eigenschaften des Kompositmaterials und die erreichte thermische Ankopplung zwischen beiden Komponenten ist im Ergebnis zwar besser, jedoch für viele Einsatzbedingungen keineswegs optimal.

So kommt es beispielsweise immer infolge der unterschiedlichen thermischen Ausdehnung von Trägermaterial und Beschichtung bei raschen Temperaturwechseln regelmäßig zu Festigkeitsproblemen in Verbindung mit einer Ablösung der funktionellen Beschichtung. Derartige Probleme treten insbesondere bei Temperierungsprozessen, bei Kalzinierungen und Adsorbens-Aktivierungen auf. Zudem wird mit einer zunehmenden Dicke der Beschichtung des funktionellen Materials der Wärmetransport im Komposit stark eingeschränkt.

In WO 02/40744 A1 wird ein Verfahren beschrieben, das darauf beruht, dass mittels eines Laserverfahrens Keramikbeschichtungen hergestellt werden. Diesbezüglich wird auf einem Substrat, welches aus Metall, einer Metalllegierung oder Keramik bestehen kann, Keramikpulver aufgebracht. Das in WO 02/40744 A1 beschriebene Verfahren sieht in einem ersten Schritt vor, mit Hilfe eines Lasers die Oberfläche des Substrates aufzuschmelzen, um anschließend das Keramikpulver zu schmelzen. Diesbezüglich werden verschiedene Leistungsstufen beim Laser eingestellt.

Aus den vorgenannten Problemen ergibt sich die der Erfindung zugrunde liegende Aufgabe, ein Verfahren zur Herstellung eines funktionellen Kompositmaterials anzugeben, mit dem die erwähnten Nachteile und funktionellen Beeinträchtigungen nachhaltig vermieden werden können. Das geforderte Kompositmaterial soll eine hohe thermische Belastbarkeit aufweisen, die mechanische Bindung zwischen Trägermaterial und funktioneller Beschichtung soll auch mit höheren Schichtdicken hohen Belastungen standhalten können und der Wärmetransport im Komposit soll technisch optimale Werte aufweisen. Das geforderte Kompositmaterial soll vielfältig anwendbar sein.

Die Aufgabe wird mit einem Verfahren zur Herstellung eines Kompositmaterials mit den Merkmalen des Anspruchs 1 gelöst. Die jeweiligen Unteransprüche geben zweckmäßige bzw. vorteilhafte Ausführungsformen des Herstellungsverfahrens an.

Die Stoffgrenze zwischen Träger und funktionellem Oberflächenmaterial ist nicht plan. Die Stoffgrenze ist vielmehr innerhalb einer Grenzschicht strukturiert. Diese Grenzschicht weist eine als Vernetzungstiefe bezeichnete Dicke auf. Sie ist in Richtung des funktionellen Oberflächenmaterials von einer oberen Grenze und in Richtung des Trägers von einer unteren Grenze beschränkt. Als Resultat davon ist der Träger auf seiner entsprechenden Oberfläche mit dem funktionellen Oberflächenmaterial verzahnt. Dies bedingt eine stark vergrößerte Anbindung des funktionellen Oberflächenmaterials auf der Oberfläche des Trägers mit einem intensiven thermischen Kontakt zwischen beiden Komponenten. Der thermische Übergangswiderstand zwischen Träger und Oberflächenmaterial ist dadurch minimiert.

Die Stoffgrenze ist als eine zusammenhängende Folge von oberflächlichen Ausformungen des Trägers mit Zwischenräumen ausgebildet, wobei jede Ausformung eine Höhe aufweist, die gleich der Vernetzungstiefe ist. Zusätzlich dazu sind innerhalb einer einem Vielfachen der Vernetzungstiefe entsprechenden horizontalen Breite der Grenzschicht mindestens eine Ausformung und mindestens ein Zwischenraum angeordnet.

Dies bedingt eine optimale Abstimmung zwischen der Höhe der Ausformungen und damit der Dicke der Grenzschicht bzw. deren Vernetzungstiefe und der Breite der Ausformungen, die für eine optimale mechanische Festigkeit und einen guten thermischen Kontakt im Komposit notwendig sind.

Erfindungsgemäß wird zum Erzeugen der Ausformungen ein Verfahren zum Aufwachsen einer Oberflächenstruktur angewendet. Bei erfindungsgemäßer Verwendung von Zeolithen wird auf eine konsumtive Aufkristallisation zurückgegriffen und eine kontrollierte Trägerauflösung mit einem kontrollierten Zeolithwachstum erfolgt.

Zweckmäßigerweise weisen die Ausformungen eine erste Formbreite im Bereich der unteren Grenze und eine von der ersten Formbreite verschiedene zweite Formbreite im Bereich der oberen Grenze der strukturierten Grenzschicht auf. Die damit erreichbare Kontur der Ausformungen kann den thermischen Kontakt zwischen Träger und Beschichtung verbessern bzw. trägt zur verbesserten Festigkeit des Kompositaufbaus bei.

Bei einer vorteilhaften Ausführungsform verläuft die resultierende Stoffgrenze auf einer mindestens der doppelten Vernetzungstiefe entsprechenden horizontalen Breite wiederholt entlang der unteren Grenze und der oberen Grenze der strukturierten Grenzschicht. Ein derartiges Verhältnis zwischen Breite und Höhe der Ausformungen erweist sich in thermischer, chemischer und mechanischer Hinsicht als besonders günstig.

Die Länge der alternierenden Stoffgrenze ist zweckmäßigerweise so bemessen, dass sie das mindestens 1,1-Fache, vorzugsweise 1,3 bis 2,5-Fache, einer Länge einer ebenen Stoffgrenze des Trägers beträgt. Die damit einhergehende entsprechend vergrößerte Kontaktfläche zwischen Träger und funktionellem Oberflächenmaterial hat sich als thermisch vorteilhaft herausgestellt. Die Vernetzungstiefe weist einen Wert im Bereich von 5 bis 100 µm, insbesondere von 5 bis 60 µm, auf.

Die Ausformungen können in unterschiedlichen Formen ausgebildet sein. Bei einer ersten Variante bilden die Ausformungen eine Reihe von Stegen mit einer rechteckigen, schwalbenschwanzartigen und/oder welligen Kontur. Die rechteckige und wellige Kontur ist in Hinblick auf den thermischen Kontakt zwischen Oberflächen-material und Träger und in Hinblick auf eine einfachere Herstellung vorteilhaft, die schwalben-schwanzartige Kontur bedingt eine sehr feste mechanische Bindung im Kompositaufbau.

Die Ausformungen können auch als eine Reihe von Noppen mit einer glockenartigen, umgekehrt oder aufrecht pyramidenstumpfförmigen und/oder pilzkopfförmigen Kontur ausgebildet sein. Im Gegensatz zu den sich vorwiegend in eine Längsrichtung erstreckenden Stegen bilden die Noppen eine Berg-und-Tal-Struktur ohne Vorzugsrichtung aus.

Der Träger kann aus verschiedenen Materialien bestehen. Er kann aus einem metallischen Werkstoff, einem keramischen Werkstoff oder einem Glaswerkstoff bestehen. Er kann in Form eines Bleches oder einer Platte, eines Rohres oder eines Schwammes vorliegen. Für das Oberflächenmaterial kommen ebenfalls verschiedene Materialien in Betracht. Das Oberflächenmaterial kann ein Adsorbens, ein katalytisch aktives Material oder ein Korrosions- und/oder Antifoulingschutz, ein Isolator oder ein elektrisch funktionales Material sein.

Das erfindungsgemäß hergestellte Kompositmaterial soll im Folgenden anhand von Ausführungsbeispielen näher erläutert werden. Es werden für gleiche bzw. gleich wirkende Teile die selben Bezugszeichen verwendet. Zur Verdeutlichung dienen die beigefügten Figuren 1 bis 5. Es zeigt
- Fig. 1: eine beispielhafte erste Ausführungsform mit einer Folge von Ausformungen in einer rechteckigen Kontur,
- Fig. 1a: eine Trägeroberfläche in einer beispielhaften Draufsicht,
- Fig. 2: modifizierte Ausführungsformen der Ausformungen aus Fig. 1 als Trapez- bzw. Schwalbenschwanzform,
- Fig. 3: Ausformungen mit einer Wellenkontur,
- Fig. 4: Ausformungen mit einer Pilzkopfkontur,
- Fig. 5: Ausformungen in Form von glockenförmigen Noppen.

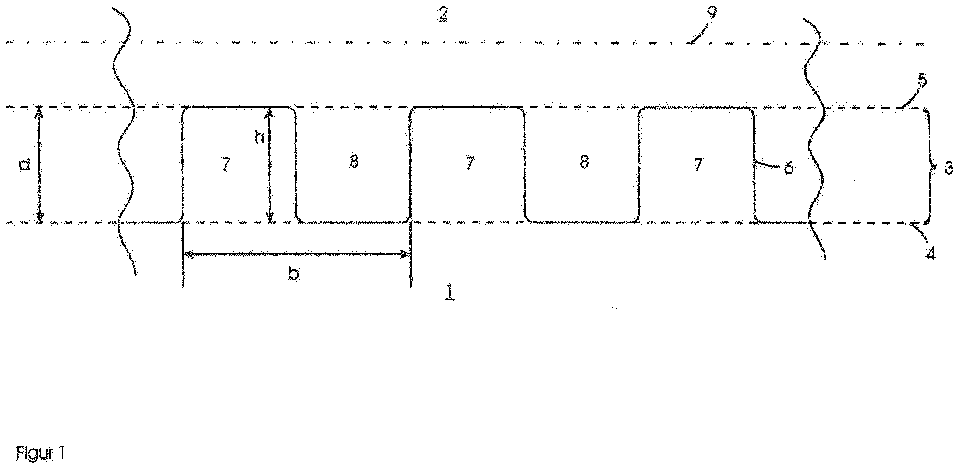

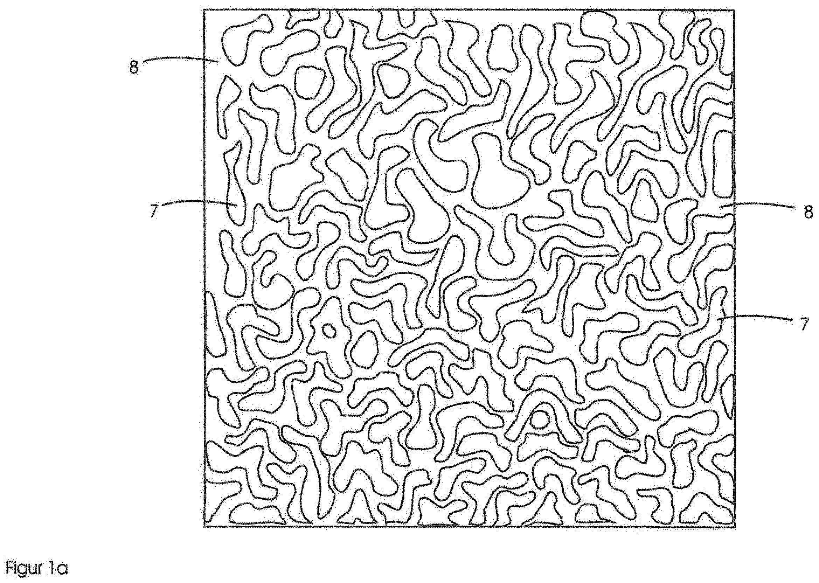

Fig. 1 zeigt einen Träger 1 mit einem aufgelagerten funktionellen Oberflächenmaterial 2, das den Träger vollständig bedeckt. Die der Oberflächenschicht zugewandte Oberfläche des Trägers weist eine Reihe von Ausformungen 7 mit zwischen den Ausformungen gelegenen Zwischenräumen 8 auf. Die Gesamtheit der Ausformungen und Zwischenräume bildet eine strukturierte Grenzschicht 3 mit einer Vernetzungstiefe d. Die Vernetzungstiefe bezeichnet den Abstand zwischen einer unteren Grenze 4 und einer oberen Grenze 5 der strukturierten Grenzschicht. Sie entspricht dem Abstand zwischen dem höchsten und dem tiefsten Niveau der Ausformungen.

Die Höhe h jeder einzelnen Ausformung entspricht im wesentlichen der Vernetzungstiefe d der strukturierten Grenzschicht 3. Die Oberflächen der Ausformungen und der zwischen ihnen gelegenen Zwischenräume bilden die resultierende Stoffgrenze 6 zwischen dem Träger und dem Oberflächenmaterial 2, an der das Oberflächenmaterial und das Material des Trägers in unmittelbarem Kontakt stehen. Wie aus Fig. 1 zu entnehmen ist, alterniert die Stoffgrenze 6 zwischen der oberen und unteren Grenze 5 bzw. 4 der Grenzschicht 3. Ihr Verlauf wird von der Form der Ausformungen 7 und deren Zwischenräumen 8 bestimmt. Im Vergleich zu einer Stoffgrenze 9 einer planen Trägeroberfläche weist sie eine vergrößerte Länge auf. Einbindungsvermittelndes Material ist nicht vorgesehen und nicht notwendig.

Die Folge der Ausformungen 7 und deren Zwischenräumen 8 wird lateral in Bezug auf die Größe einer horizontalen Breite b festgelegt. Die horizontale Breite ist zweckmäßigerweise auf die Vernetzungstiefe d der strukturierten Grenzschicht bezogen. Sie bildet einen lateralen Maßstab für die Oberflächenstruktur des Trägers. Bei der in Fig. 1 gezeigten Ausführungsform beträgt die horizontale Breite b in etwa das Doppelte der Vernetzungstiefe d, wobei sich innerhalb dieser Skalierung mindestens eine Ausformung 7 und ein Zwischenraum 8 befinden. Die horizontale Breite b bildet keine Gitterkonstante im engeren Sinn. Die Breite der Ausformungen und ihrer Zwischenräume kann im Einzelnen variieren. Von Bedeutung ist vielmehr die Anzahl der Ausformungen innerhalb der durch die horizontalen Breite b vorgegebenen Skalierung bzw. das Verhältnis von b zur Vernetzungstiefe d.

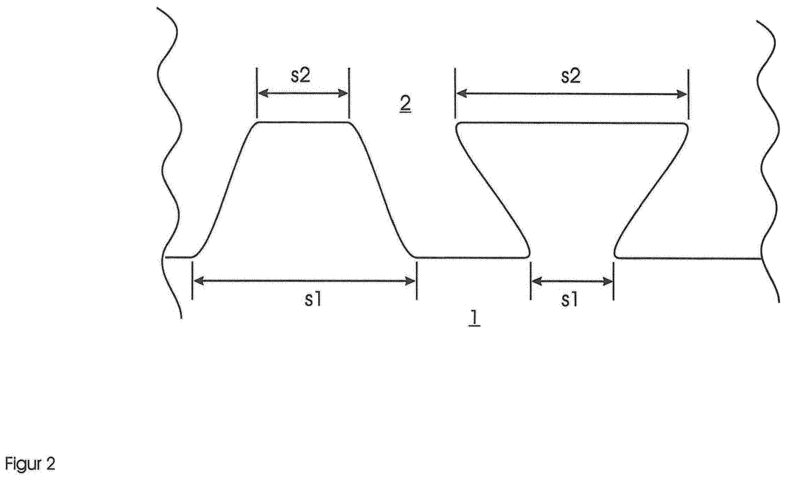

Wie in Fig. 1a in der Draufsicht dargestellt, können die Ausformungen in lateraler Richtung völlig unregelmäßig geformt sein, sodass die in den Figuren 1 und 2 definierten Größen zur Charakterisierung der Ausformungen hinsichtlich ihrer Breite um einen Mittelwert schwanken. Die Vernetzungstiefe ist im überwiegenden Teil der Trägeroberfläche im Wesentlichen gleich.

Wie in Fig. 2 und den folgenden Figuren dargestellt, können die Ausformungen eine von der rechteckigen Form abweichende Kontur aufweisen. In einem solchen Fall ist zwischen einer ersten Formbreite s1 im Bereich des Fußes der Ausformung an der unteren Grenze 4 und einer zweiten Formbreite s2 im Bereich der oberen Grenze 5 der strukturierten Grenzschicht zu unterscheiden. Bei einer in Fig. 2 links im Bild gezeigten trapezförmigen Ausformung mit verbreiterter Basis ist die erste Formbreite s1 größer als die zweite Formbreite s2. Bei einer in Fig. 2 rechts dargestellten schwalbenschwanzförmigen Ausformung ist die zweite Formbreite s2 größer als die erste Formbreite Si.
Die Werte der Formbreiten und auch ihr Größenverhältnis können in der Folge der Ausformungen auf einer Trägeroberfläche in gewissen Grenzen variieren. Die Ausformungen bilden nicht notwendigerweise ein regelmäßiges Gitter.

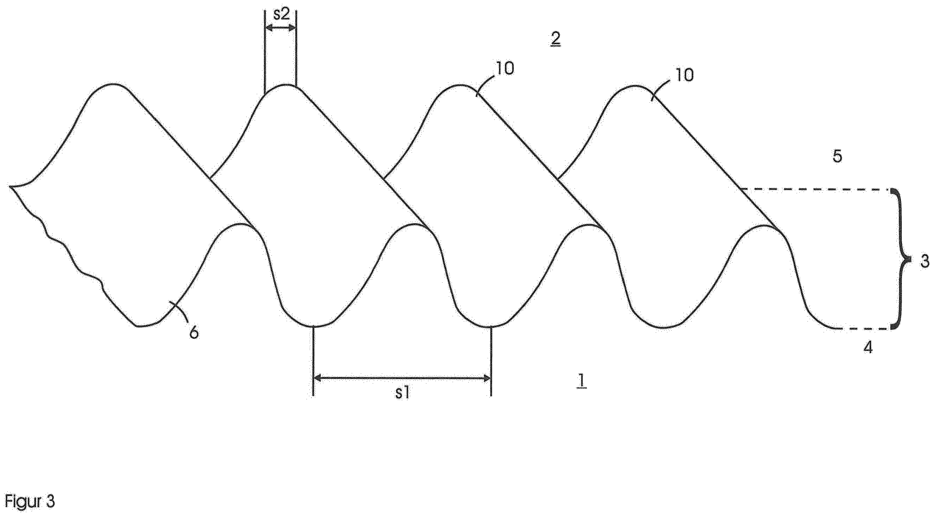

Fig. 3 zeigt Ausformungen 7 und Zwischenräume 8 in einer Wellenform. Die Stoffgrenze 6 alterniert kontinuierlich zwischen der unteren Grenze 4 und der oberen Grenze 5 der strukturierten Grenzschicht 3. Die erste Formbreite s1 entspricht dabei den horizontalen Abständen zwischen den tiefsten Punkten innerhalb der Zwischenräume 8, die zweite, in der Nähe der oberen Grenze 5 gelegene Formbreite ist bei dieser Ausführungsform im Idealfall beliebig klein. Praktisch jedoch weisen die Spitzen des wellenförmigen Verlaufs der Stoffgrenze im Bereich der Oberflächenschicht eine gewisse Abplattung auf, die zweite Formbreite s2 hat damit einen kleinen, aber endlichen Wert.

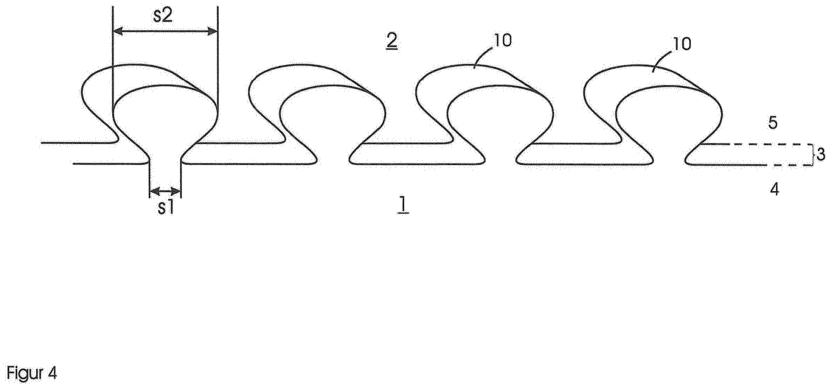

Fig. 4 zeigt Ausformungen 7 mit einer pilzkopfartigen Form. Eine im Bereich der unteren Grenze 4 breitere Form geht im Bereich zwischen den Grenzen 4 und 5 in einen verjüngten Mittelteil über und verbreitert sich im Bereich der oberen Grenze 5 wieder. Die Pilzkopfstruktur kann als eine abgerundete Ausführungsform der Schwalbenschwanzstruktur aus Fig. 2 aufgefasst werden.

Bei den in den Figuren 3 und 4 gezeigten Ausführungsformen erstrecken sich die Ausformungen 7 stegartig über einen Teilbereich der Oberfläche des Trägers, sodass deren Querschnitte über die Oberfläche des Trägers extrudiert sind.

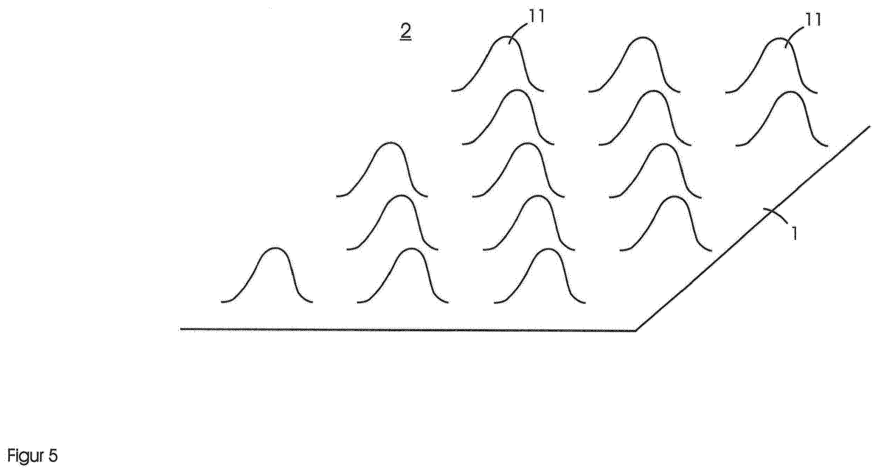

Fig. 5 zeigt eine auf der Trägeroberfläche angeordnete Noppenstruktur aus einem nicht notwendigerweise gleichmäßigen Array glockenförmiger Noppen 11 und dazwischen liegender Täler, die von der Oberflächenbeschichtung 2 überdeckt ist. Die Noppen können auch in Trapez- oder Schwalbenschwanzform vorliegen.

Die strukturierten Grenzflächen, die Verläufe der Stoffgrenzen und deren vorhergehend erläuterten Parameter lassen sich in sehr einfacher Weise durch mikroskopische Verfahren nachweisen und untersuchen. Diese werden zweckmäßigerweise mit einer digitalen Bildverarbeitung kombiniert. Aus der im Schnitt als eindimensionale Linie erkennbaren Stoffgrenze lässt sich unter der Voraussetzung einer hinreichend isotropen Strukturierung auf die zweidimensionale Kontaktfläche zwischen Träger und Oberflächenbeschichtung schließen.

Hierzu werden von den zu untersuchenden Kompositproben vorzugsweise eingebettete Querschnitte präpariert, von denen digitale mikroskopische Aufnahmen erstellt werden. Die Vergrößerung wird zweckmäßigerweise so gewählt, dass der zu analysierende Bildausschnitt mindestens 6, besser aber 10 Ausformungen umfasst. Der Betrachtungsmaßstab wird zum Einstellen eines zweckmäßigen Verhältnisses zwischen Bildpixel und Vernetzungstiefe zweckmäßig eingestellt. Unter Verwendung einer üblichen Bildverarbeitungssoftware, insbesondere eines vektorbasierten Zeichenprogramms, lassen sich die vorhergehend beschriebenen Größen, d.h. die Vernetzungstiefe, die Breite der Ausformungen und die Länge der resultierenden Stoffgrenze, sehr leicht ermitteln.

Zur Einschätzung der entstandenen Oberflächenstruktur und Vernetzungstiefe wird von dem Schnitt des funktionellen Kompositmaterials ausgegangen. Davon wird ein etwa 1 Millimeter langer Abschnitt in einer 100-fachen Vergrößerung auf ein Bildformat von beispielsweise 1024 x 768 Pixeln übertragen. Ist die resultierende Oberflächenstruktur anisotrop, empfiehlt sich eine Anfertigung der Schnitte in verschiedenen Winkeln mit einer entsprechenden nachfolgenden Auswertung der dabei entstehenden Aufnahmen.

Als besonders zweckmäßig haben sich Vernetzungstiefen im Bereich von 15 bis 60 µm erwiesen. Vernetzungstiefen ab 5 µm und bis zu 100 µm sind jedoch ohne weiteres realisierbar und zeigen ebenfalls gute Eigenschaften beim Einsatz des Komposits. Im Querschnitt lässt sich die Länge der resultierenden Stoffgrenze 6 ermitteln und mit der Länge der Stoffgrenze bei einer unstrukturierten Oberfläche des Trägers vergleichen.

Versuche haben gezeigt, dass die Ausformungen, insbesondere deren Breite, deren Höhe bzw. die daraus resultierende Vernetzungstiefe besonders dann zweckmäßig gewählt sind, wenn die resultierende Stoffgrenze um einen Faktor von mindestens 1,4 gegenüber der Stoffgrenze einer planen, unstrukturierten Trägeroberfläche vergrößert ist.

Die gezeigten Ausführungsbeispiele des Kompositmaterials weisen eine deutlich verbesserte mechanische Festigkeit auch unter thermischer Beanspruchung auf. Besonders bei funktionellen Oberflächenschichten mit spröden Materialeigenschaften ist die Gefahr eines Abplatzens der Beschichtungen unter thermischen und mechanischen Belastungen deutlich reduziert. Die infolge der Ausformungen vergrößerte Stoffgrenze erhöht den Wärmetransport zwischen Träger und funktioneller Oberflächenschicht und ermöglich somit dickere Beschichtungen bei gleicher Effizienz in Anwendungen, die eine starke Wärmetönung aufweisen. Dies ist insbesondere bei Katalyse- und Adsorptionsprozessen der Fall.

Zur Herstellung einer Oberfläche des Trägers in einer der genannten Ausführungsformen wird erfindungsgemäß auf eine konsumtive Aufkristallisation bei Verwendung von Zeolithen zurückgegriffen. Es erfolgt dabei eine kontrollierte Trägerauflösung mit einem kontrollierten Zeolithwachstum. Dabei entsteht eine Berg- und Tal-Struktur mit schwalbenschwanzförmigen Noppen gemäß der Ausführungsform aus Fig. 5.

Eine Zeolithschicht mit den erwähnten Eigenschaften lässt sich in einem naßchemischen Verfahren beispielsweise dadurch erzeugen, dass einer Reaktionslösung aus einem Teil Phosphorsäure (H3PO4), 0,38 Teilen Siliziumdioxid (SiO2) in Form von Kieselsol, 3 Teilen Morpholin und 70 Teilen Wasser ein Trägermaterial aus Aluminium oder einer Aluminiumlegierung in einer Menge hinzu gegeben wird, bei der das Verhältnis der in Quadratzentimer gemessenen Oberfläche des Trägermaterials zum in Milliliter angegebenen Volumen der Lösung etwa 2 bis 5 beträgt. Die so angesetzte Mischung wird in einem Druckgefäß für 96 Stunden auf eine Temperatur von 175 °C erwärmt und nachfolgend in Wasser ausgewaschen. Als Resultat der Behandlung entsteht eine SAPO-34-Zeolith-schicht auf der Oberfläche des Trägers.

### Bezugszeichenliste

- 1: Träger
- 2: Funktionelles Oberflächenmaterial
- 3: Grenzschicht
- 4: untere Grenze
- 5: obere Grenze
- 6: Stoffgrenze
- 7: Ausformung

- 8: Zwischenraum
- 9: Stoffgrenze einer planen Trägeroberfläche
- 10: Steg
- 11: Noppe

## Patentansprüche

1. Verfahren zur Herstellung eines funktionellen Kompositmaterials, bestehend aus einem Träger (1) aus metallischem Werkstoff und/oder aus keramischem Werkstoff und/oder aus Glaswerkstoff und einem funktionellen Oberflächenmaterial (2), wobei
der Träger eine strukturierte Grenzschicht (3) mit einer unteren Grenze (4) und einer oberen Grenze (5) mit einer Vernetzungstiefe (d) zwischen der unteren und oberen Grenze und einer zwischen der unteren und oberen Grenze alternierenden Stoffgrenze (6) an der dem funktionellen Oberflächenmaterial zugewandten Oberflächen aufweist, wobei die Stoffgrenze (6) als eine zusammenhängende Folge von oberflächlichen Ausformungen (7) des Trägers mit Zwischenräumen (8) ausgebildet ist, wobei jede Ausformung eine Höhe (h) aufweist, die gleich der Vernetzungstiefe ist, und innerhalb einer einem Vielfachen der Vernetzungstiefe entsprechenden horizontalen Breite (b) der Grenzschicht mindestens eine Ausformung und mindestens ein Zwischenraum (8) liegt,
**dadurch gekennzeichnet, dass**
zum Erzeugen der Ausformungen ein Verfahren zum Aufwachsen einer Oberflächenstruktur angewendet wird, wobei bei Verwendung von Zeolithen auf eine konsumtive Aufkristallisation zurückgegriffen wird und eine kontrollierte Trägerauflösung mit einem kontrollierten Zeolithwachstum erfolgt.

2. Verfahren nach Anspruch 1,
**dadurch gekennzeichnet, dass**
die Ausformungen (7) eine erste Formbreite (s1) im Bereich der unteren Grenze (4) und eine von der ersten Formbreite verschiedene zweite Formbreite (s2) im Bereich der oberen Grenze (4) der strukturierten Grenzschicht (3) aufweisen.

3. Verfahren nach Anspruch 1 oder 2,
**dadurch gekennzeichnet, dass**
die resultierende Stoffgrenze (6) auf einer mindestens der doppelten Vernetzungstiefe (2d) entsprechenden horizontalen Breite (b) wiederholt an der unteren Grenze (4) und an der oberen Grenze (5) der strukturierten Grenzschicht (3) verläuft.

4. Verfahren nach einem der Ansprüche 1 bis 3,
**dadurch gekennzeichnet, dass**
eine Länge der alternierenden Stoffgrenze (6) das mindestens 1,1-Fache, vorzugsweise 1,3 bis 2,5-Fache, einer Länge einer ebenen Stoffgrenze (9) des Trägers (1) beträgt.

5. Verfahren nach einem der Ansprüche 1 bis 4,
**dadurch gekennzeichnet, dass**
die Vernetzungstiefe (d) einen Wert von 5 bis 100 µm, insbesondere 5 bis 60 µm, aufweist.

6. Verfahren nach einem der Ansprüche 1 bis 5,
**dadurch gekennzeichnet, dass**
die Ausformungen als ein isotropes Muster (10) mit einer im Schnitt rechteckigen, trapezförmigen, schwalbenschwanzartigen und/oder welligen Kontur ausgebildet werden.

7. Verfahren nach einem der Ansprüche 1 bis 6,
**dadurch gekennzeichnet, dass**
die Ausformungen als ein Array von Noppen (11) mit einer glockenartigen, umgekehrt oder aufrecht pyramidenstumpfförmigen und/oder pilzkopfartigen Kontur ausgebildet werden.

8. Verfahren nach einem der Ansprüche 1 bis 7,
**dadurch gekennzeichnet, dass**
das Oberflächenmaterial (2) ein Adsorbens und/oder ein katalytisch aktives Material und/oder ein Isolator und/oder ein elektrisch aktives Material und/oder ein Korrosionsschutz und/oder Antifoulingschutz ist.

## Claims

1. A method for producing a functional composite material comprised of a carrier (1) of a metallic material and/or of a ceramic material and/or of a glass material, and a functional surface material (2), wherein
the carrier comprises a structured boundary layer (3) with a lower boundary (4) and an upper boundary (6) having a cross-linking depth (d) between the lower and upper boundaries, and a medium barrier (6) alternating between the lower and upper boundaries at the surfaces facing the functional surface material, wherein
the medium barrier (6) is formed as a coherent succession of superficial formations (7) of the carrier with interspaces (8), wherein each formation comprises a height (h) which is equal to the cross-linking depth, and at least one formation and at least one interspace (8) are present within a horizontal width (b) of the boundary layer corresponding to a multiple of the cross-linking depth,
**characterized in that**
for producing the formations, a method for allowing a surface structure to grow is applied, wherein, when zeolites are used, consumptive crystal growth is referred to, and a controlled carrier dissolution is performed with a controlled zeolite growth.

2. The method according to claim 1,
**characterized in that**
the formations (7) comprise a first shape width (s1) in the area of the lower boundary (4), and a second shape width (s2) different from the first shape width in the area of the upper boundary (4) of the structured boundary layer (3).

3. The method according to claim 1 or 2,
**characterized in that**
the resulting medium barrier (6) extends over a horizontal width (b) corresponding to at least twice the cross-linking depth (2d) repeatedly at the lower boundary (4) and the upper boundary (5) of the structured boundary layer (3).

4. The method according to any one of claims 1 to 3,
**characterized in that**
the length of the alternating medium barrier (6) is at least 1.1 times, preferably 1.3 to 2.5 times the length of a planar medium barrier (9) of the carrier (1).

5. The method according to any one of claims 1 to 4,
**characterized in that**
the cross-linking depth (d) comprises a value of 5 to 100 µm, in particular 5 to 60 µm.

6. The method according to any one of claims 1 to 5,
**characterized in that**
the formations are formed as an isotropic pattern (10) having a rectangular, trapezoidal, dovetail-like and/or undulated contour as seen in a section.

7. The method according to any one of claims 1 to 6,
**characterized in that**
the formations are formed as an array of burls (11) having a bell-like, reversed or upright truncated pyramid-shaped and/or mushroom head-like contour.

8. The method according to any one of claims 1 to 7,
**characterized in that**
the surface material (2) is an adsorbent and/or a catalytically active material and/or an insulator and/or an electrically active material and/or an anticorrosion material and/or an antifouling material.

## Revendications

1. Procédé pour la production d'un matériau composite fonctionnel, constitué d'un support (1) en matériau métallique et/ou en matériau céramique et/ou en matériau à base de verre, et d'un matériau de surface fonctionnel (2), dans lequel
le support possède une couche limite structurée (3) avec une limite inférieure (4) et une limite supérieure (5) avec une profondeur de réticulation (b) entre la limite supérieure et la limite inférieure, et une limite matérielle (6) qui alterne entre la limite inférieure et la limite supérieure, au niveau des surfaces tournées vers le matériau de surface fonctionnel, dans lequel
la limite matérielle (6) est réalisée sous la forme d'une succession cohérente de conformations surfaciques (7) du support avec des espaces intermédiaires (8), dans lequel chaque conformation présente une hauteur (h) qui est égale à la profondeur de réticulation et, à l'intérieur d'une largeur horizontale (b), correspondant à un multiple de la profondeur de réticulation, de la couche limite, il existe au moins une conformation et au moins un espace intermédiaire (8),
**caractérisé en ce que**, pour engendrer les conformations, on emploie une procédure pour faire croître une structure superficielle et, en utilisant des zéolites, on a recours à une déposition par cristallisation du type à consommation et il se produit une dissolution contrôlée du support avec une croissance contrôlée des zéolites.

2. Procédé selon la revendication,
**caractérisé en ce que** les conformations (7) présentent une première largeur (s1) dans la zone de la limite inférieure (4), et une seconde largeur (s2), différente de la première largeur, dans la zone de la limite supérieure (4) de la couche limite structurée (3).

3. Procédé selon la revendication 1 ou 2,
**caractérisé en ce que** la limite matérielle résultante (6) s'étend, sur une largeur horizontale (b) correspondant au moins au double de la profondeur de réticulation (2d), de façon répétée à la limite inférieure (4) et à la limite supérieure (5) de la couche limite structurée (3).

4. Procédé selon l'une des revendications 1 à 3,
**caractérisé en ce qu'**une longueur de la limite matérielle alternante (6) s'élève au moins à 1,1 fois, de préférence 1,3 à 2,5 fois une longueur d'une limite matérielle plane (9) du support (1).

5. Procédé selon l'une des revendications 1 à 4,
**caractérisé en ce que** la profondeur de réticulation (b) a une valeur de 5 à 100 µm, en particulier 5 à 60 µm.

6. Procédé selon l'une des revendications 1 à 5,
**caractérisé en ce que** les conformations sont réalisées comme un motif isotrope (10) avec un contour à section rectangulaire, trapézoïdale, en forme de queue d'aronde et/ou ondulée.

7. Procédé selon l'une des revendications 1 à 6,
**caractérisé en ce que** les conformations sont réalisées comme un réseau de boutons avec un contour en forme de cloche, en forme de tronc de pyramide droit ou inversé et/ou en forme de champignon.

8. Procédé selon l'une des revendications 1 à 7,
**caractérisé en ce que** le matériau de surface (2) est un matériau adsorbant et/ou un matériau actif sur le plan catalytique et/ou un matériau isolant et/ou un matériau actif sur le plan électrique et/ou un matériau de protection anticorrosion et/ou un matériau de protection antifouling.
